# EUROPÄISCHE PATENTSCHRIFT

(11) **EP 0 758 817 B1**
(45) Veröffentlichungstag und Bekanntmachung des Hinweises auf die Patenterteilung: **25.07.2001**
(21) Anmeldenummer: 95112740.6
(22) Anmeldetag: 12.08.1995
(51) Int. Cl.: H03G 5/02, H03G 5/00, H03H 17/02

(54) **Equalizer für digitalisierte Signale**
Equaliser for digital signals
Egaliseur pour signaux numériques

(43) Veröffentlichungstag der Anmeldung: 19.02.1997
(73) Patentinhaber: Micronas GmbH, 79108 Freiburg (DE)
(72) Erfinder: Menkhoff, Andreas, D-79098 Freiburg (DE)

(56) Entgegenhaltungen:
- IEEE TRANSACTIONS ON ACOUSTICS, SPEECH AND SIGNAL PROCESSING, Bd. ASSP-35, Nr. 1, Januar 1987 NEW YORK (US), Seiten 118-120, P. REGALIA E.A. 'Tunable digital frequency response equalization filters.'
- DIGITAL SIGNAL PROCESSING, NEW YOEK, APR. 11 - 14, 1988, Bd. 3, 11.April 1988 INSTITUTE OF ELECTRICAL AND ELECTRONICS ENGINEERS, Seiten 1786-1789, XP 000140074 CHARBONNIER A ET AL 'DESIGN OF NEARLY PERFECT NON UNIFORM QMF FILTER BANKS'
- PROCEEDINGS TENCON 87; 1987 IEEE REGION 10 CONFERENCE; 25-28 AUGUST 1987, SEOUL, KOREA, Bd. 3 of 3, 25. - 28.August 1987 NEW YORK (US), Seiten 945-948, C. S. KUMAR 'On the design of nonlinear phase quadrature mirror filters (QMF) for subband coder applications.'

## Beschreibung

Die Erfindung betrifft einen Equalizer für digitalisierte Signale, der eine Anzahl von sich aneinander anschließenden Frequenzbereichen aufweist, in denen das zugeführte Signal innerhalb bestimmter Grenzen beliebig in der Amplitude einstellbar sein soll. Derartige Schaltungen sind in mehr oder weniger aufwendiger Form als Klangregelnetzwerke bei Audiogeräten bekannt, wobei ursprünglich nur analoge Signale verarbeitet wurden. Equalizer werden überall dort verwendet, wo eine variable, frequenzabhängige Pegelsteuerung erwünscht ist. So ermöglicht z.B. ein Equalizer im Videosignalbereich durch Anhebung oder Absenkung bestimmter Videofrequenzbereiche eine optische Verbesserung eines Bildübertragungssystems oder einer Bildwiedergabe. Mit zunehmender Digitalisierung der Signalverarbeitung werden derartige Equalizer auch in digitaler Ausführung realisiert. Aufwendige Lösungen bilden dabei digitale Filterbänke, die das zugeführte Digitalsignal mittels einer Vielzahl von digitalen Bandpässen in einzelne Frequenzbereiche zerlegen und mittels einer individuellen Verstärkung der bandpaßgefilterten Signale den gewünschten Amplitudengang erzeugen. Eine derartige Filterbank mit variablen Bandpässen für einen digitalen Equalizer ist beispielsweise in "IEEE Transactions on Acoustic, Speech and Signal Processing, Band ASSP-35, Nr. 1, Januar 1987, Seiten 118 bis 120 in einem Aufsatz von P.A. Rigalia und S.K. Mitra: "Tunable, Digital Frequency Response Equalization Filters" beschrieben. Die Bandbreite der dabei verwendeten Bandpässe und ihre Flankensteilheit werden durch die jeweilige Filterordnung und Güte bestimmt, die sich aus den Anforderungen des Equalizers ergeben. Die gewünschte Beeinflussung des Frequenzganges geschieht dann durch Verstärkung bzw. Absenkung der einzelnen Bandpässe.

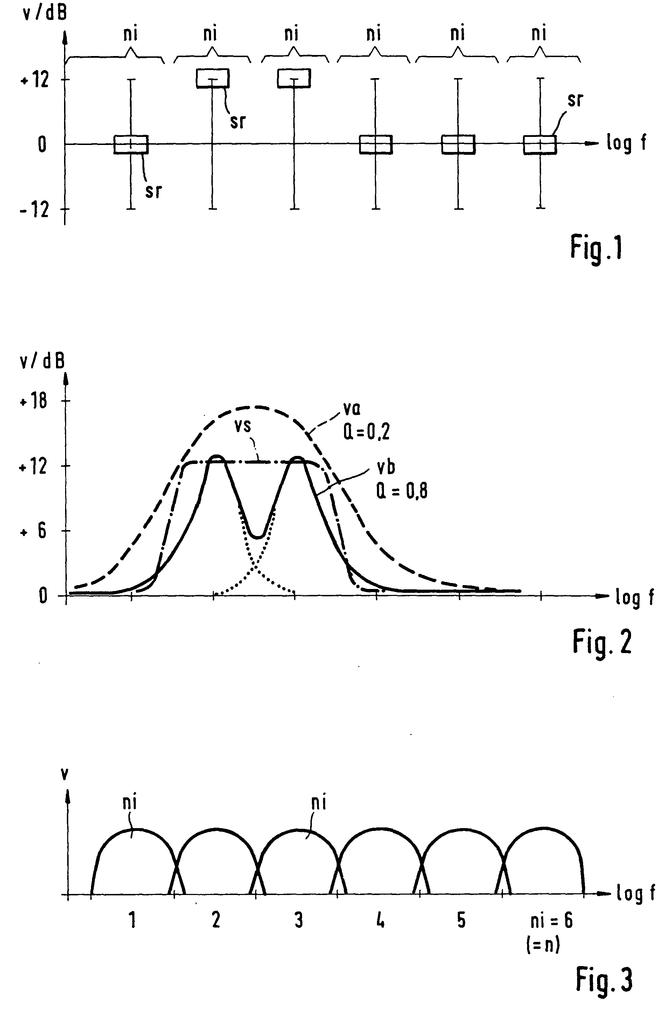

Schwierigkeiten ergeben sich bei dieser Art von Equalizer durch die meist unbefriedigende Selektivität der verwendeten Bandpässe. Wählt man z.B. die Bandbreite der einzelnen Bandpässe relativ schmal und ihre Güte relativ hoch (vgl. in Fig. 2 den Kurvenverlauf vb, der einer Güte von Q = 0, 8 entspricht), so ist die gegenseitige Überlappung benachbarter Bandpässe gering. Dies hat jedoch den Nachteil, daß bei einem gemeinsamen Anheben oder Absenken zweier benachbarter Frequenzbereiche der Amplitudengang in diesem Bereich nicht eben ist, sondern einen unerwünschten Einbruch bzw. eine unerwünschte Verstärkung im Zwischenfrequenzbereich aufweist. Wählt man die Bandbreite der einzelnen Bandpässe jedoch relativ breit und ihre Güte relativ klein (vgl. in Fig. 2 den Kurvenverlauf va, der einer Güte Q = 0,2 entspricht), so kann bei geeigneter Wahl der unerwünschte Einbruch zwischen zwei benachbarten Bandpässen vermieden werden. Dabei treten jedoch neue Schwierigkeiten auf. Durch die große Bandbreite und geringe Güte der Bandpässe bleibt deren Wirkung nämlich nicht mehr auf den jeweiligen Frequenzbereich beschränkt, sondern beeinflußt auch deutlich die Nachbarbereiche. Dies hat beispielsweise zur Folge, daß bei einer gemeinsamen Anhebung benachbarter Bandpässe auf 12 dB ein großer Überlappungsbereich auftritt, in dem sich die beiden Filterkurven überlagern, so daß in diesem Überlappungsbereich die Verstärkung deutlich größer wird (in Fig. 2 werden statt der gewünschten 12 dB dort ungefähr 17 dB erreicht). In der Praxis muß man daher bei herkömmlichen Equalizern einen Kompromiß zwischen diesen beiden Grenzen suchen.

Durch die Wahl steilflankiger Bandpässe, die jedoch sehr rechenintensiv und damit schaltungsaufwendig sind, läßt sich dieser Konflikt mildern. Für viele Anwendungen im Konsumbereich, der auch Personal-Computer im Multimediabetrieb oder sonstige digitale Signalverarbeitungsschaltungen mit einschließt, wird eine effektive, aber weniger aufwendige Lösung für einen digitalen Equalizer gesucht, die sich insbesondere zur monolithischen Integration in einer digitalen Signalverarbeitungsschaltung eignet.

Aufgabe der Erfindung ist es daher, eine verbesserte Schaltung für einen digitalen Equalizer anzugeben, dessen Frequenzbereiche entsprechend dem vorgegebenen Amplitudengang möglichst genau angehoben oder abgesenkt werden können, wobei in den Zwischenbereichen ein möglichst glatter Übergang ohne Überschwinger oder Lücken stattfinden soll.

Die Aufgabe wird nach den Merkmalen des Anspruchs 1 für einen Equalizer mit n Frequenzbereichen für digitalisierte Signale auf folgende Weise gelöst:
- der Equalizer mit n Frequenzbereichen für digitalisierte Signale enthält n-1 in Signalflußrichtung kaskadierte Filterschaltungen, die digitale Tief- und digitale Hochpässe enthalten, mit denen ein gewünschter Amplitudengang eingestellt ist, wobei die Selektionsflanken der digitalen Tief- und digitalen Hochpässe die Frequenzgrenze zwischen jeweils benachbarten Frequenzbereichen definieren,
- die n-1 Filterschaltungen enthalten in Signalflußrichtung jeweils eine Parallelschaltung mit einem der digitalen Tiefpässe und einem der digitalen Hochpässe, wobei deren jeweilige Frequenzgänge durch komplementäre Übertragungsfunktionen miteinander verkoppelt und deren Ausgänge über eine Kombinationsstufe wieder zusammengeschaltet sind,
- eine relative Amplitudenanhebung oder -absenkung in Richtung aufsteigender Frequenzen, zwischen benachbarten Frequenzbereichen erfolgt in der zugehörigen Filterschaltung mittels Gewichtung der Ausgangssignale des digitalen Hoch- und Tiefpasses, wobei
   -- für die relative Amplitudenabhebung die Ausgangssignale des digitalen Hochpasses gegenüber denen des digitalen Tiefpasses stärker gewichtet sind oder
   -- für die relative Amplitudenabsenkung die Ausgangssignale des digitalen Tiefpasses gegenüber denen des digitalen Hochpasses stärker gewichtet sind, und
- die Gewichtungseinstellung erfolgt durch eine Steuereinrichtung, die aus einem zugeführten Equalizer-Steuersignal modifizierte Steuersignale entsprechend der Kaskadierung der Filterschaltungen bildet.

Mittels eines solchen Equalizers kann der vom Benutzer vorgegebene Amplitudenverlauf sehr viel genauer approximiert werden, als es mit bisherigen Equalizer-Schaltungen, die mit parallelgeschalteten, voneinander unabhängigen Bandpässen arbeiten, möglich ist. Der Equalizer nach der Erfindung basiert auf voneinander abhängigen, kaskadierten Filterschaltungen. Jede Filterschaltung enthält dabei einen Tiefpaß und Hochpaß mit zueinander komplementären Übertragungsfunktionen, wobei die Durchlaßverstärkung im Gegensatz zur Sperrbandunterdrückung jeweils einstellbar ist. Der Absolutpegel jedes Filterbereiches wird durch die Kaskadierung der Filterschaltungen von sämtlichen vorausgehenden und nachfolgenden Filterschaltungen abhängig. Allgemein benötigt man für einen Equalizer mit n Frequenzbändern n-1 kaskadierte Filterschaltungen oder Filterelemente. Die gegenseitige Abhängigkeit der einzelnen Filterschaltungen macht die Einstellung des gewünschten Amplitudenganges unübersichtlich, obwohl der zugehörige Algorithmus einfach ist, so daß ein derartiges Verfahren, insbesondere für einen rein manuell gesteuerten Equalizer, außer Betracht fällt. Bei einer monolithischen Integration läßt sich jedoch der einfache Algorithmus für die Einstellung des gewünschten Amplitudenganges leicht automatisieren, z.B. als kleines Unterprogramm ausführen.

Die Erfindung und vorteilhafte Ausführungsbeispiele werden nun anhand der Figuren der Zeichnung näher erläutert, wobei in den schematischen Ausführungsbeispielen gleiche Schaltungsteile oder Signale mit den gleichen Bezugszeichen bezeichnet sind:
Fig. 1 zeigt schematisch eine manuelle Einstelleinrichtung für einen Equalizer,
Fig. 2 zeigt Beispiele für unerwünschte oder erwünschte Amplitudengänge,
Fig. 3 zeigt schematisch die zu Fig. 1 und Fig. 2 gehörenden Frequenzbereiche,
Fig. 4 zeigt als Blockschaltbilid eine Filterschaltung nach der Erfindung,
Fig. 5 zeigt einige zugehörige Amplitudengänge,
Fig. 6 zeigt ein Ausführungsbeispiel eines Equalizers mit zwei Filterschaltungen,
Fig. 7 zeigt einige zugehörige Amplitudengänge,
Fig. 8 zeigt schematisch einen Equalizer mit drei Filterschaltungen und
Fig. 9 und Fig. 10 zeigen einige zugehörige Amplitudengänge.

In Fig. 1 ist schematisch eine manuelle Einstelleinrichtung für einen Equalizer für Audiosignale dargestellt. Er enthält sechs Schieberegler sr, die jeweils einem Frequenzbereich ni zugeordnet sind. Dieser wird bei üblichen analogen oder digitalen Equalizern durch einen Bandpaß bestimmt, dessen Durchlaßverstärkung mittels des Schiebereglers sr unabhängig von den anderen Bandpässen eingestellt werden kann. Da die Empfindlichkeit des Ohres eine logarithmische Kennlinie aufweist, verwendet man für die Schieberegler den gleichen Verlauf, wodurch sich die übliche dB-Einstellung ergibt. So entspricht in Fig. 1 die Position aller Schieberegler sr dem gewünschten Amplitudengang vs des in Fig. 2 dargestellten Equalizers. Der besseren Übersicht wegen sind in allen folgenden Diagrammen die Amplitudengänge und die Frequenzachsen logorithmisch dargestellt und die einzelnen Frequenzbereiche ni dabei mit logorithmisch gleichen Breiten. Dies ist jedoch nicht zwingend und insbesondere bei digitalen Filterbänken, die z.B. in einer FFT-Technik realisiert sind, kaum einzuhalten, da dort die einzelnen Frequenzbereiche ni in der Regel im absoluten Frequenzmaßstab gleiche Bandbreiten aufweisen. Da bei Audiosignalen für den subjektiven Frequenzeindruck ebenfalls eine logarithmische Abhängigkeit gilt, ist eine im absoluten Frequenzmaßstab gleichbleibende Bandbreite für die Bandfilter unerwünscht. Durch die Verwendung von Hoch- oder Tiefpässen können die Frequenzgrenzen der einzelnen Frequenzbereiche ni auf einfache Weise beliebig vorgegeben werden, so daß eine optimale Aufteilung des gesamten Frequenzbereiches für den Equalizer nach der Erfindung möglich ist. Ein weiterer Freiheitsgrad ergibt sich, wenn auch noch die Frequenzgrenze in einigen Filterschaltungen variabel einstellbar ist.

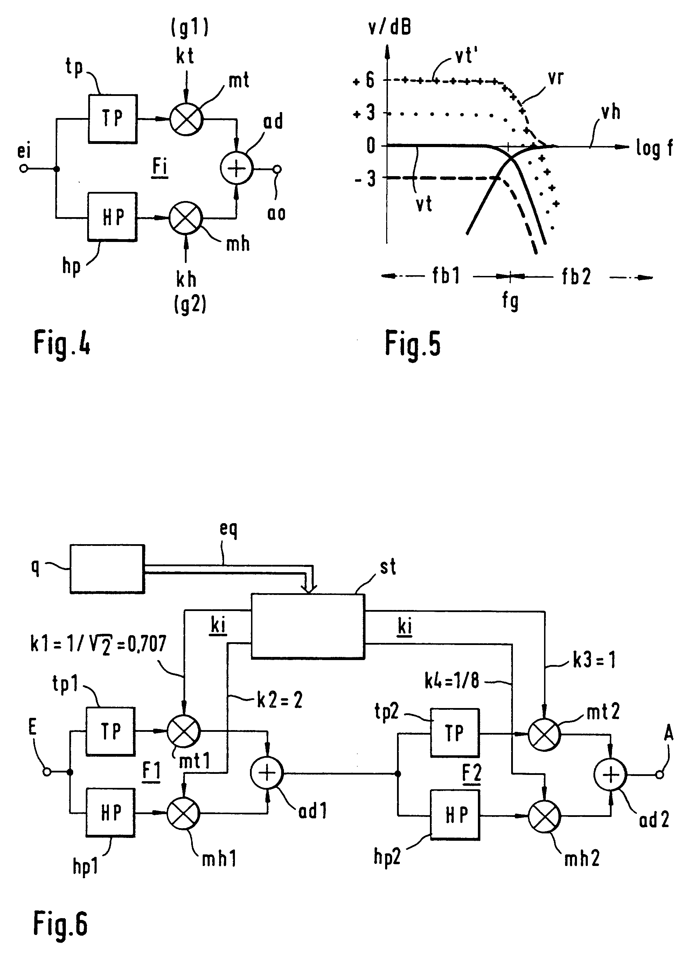

In Fig. 3 sind schematisch zur Einstelleinrichtung von Fig. 1 sechs mit Bandpässen gebildete Frequenzbereiche ni von 1 bis 6 dargestellt, wobei die einzelnen Verstärkungen einander gleich sind, der Amplitudengang v somit bis auf eine kleine Welligkeit eben verläuft und keine Anhebung oder Absenkung aufweist. Dieser glatter Verlauf gilt bei herkömmlichen Equalizern mit Bandfiltern nur für die 0-dB-Einstellung. Für alle anderen Pegel, auch wenn sie einander gleich sind, gilt dies nicht mehr, denn dann entstehen in den Zwischenbereichen Amplitudenanhebungen oder-absenkungen. Mit einem Equalizer nach der Erfindung wirkt sich jedoch eine gemeinsame Anhebung oder Absenkung nicht auf den relativen Frequenzverlauf aus, sondern entspricht einer frequenzneutralen Verstärkungseinstellung. Bei Audioanwendungen entspricht dies einer Lautstärkeregelung ohne Verfälschung des Klangeindruckes. Die einzelnen Filterbereiche ni überlappen sich in Fig. 5 geringfügig.

In Fig. 2 ist schematisch der Amplitudengang v - als db-Verlauf angegeben - für eine Equalizereinstellung nach Fig. 1 dargestellt. Der Amplitudengang vb entspricht Bandfiltern mit einer relativ hohen Güte Q = 0,8. Es ist zu erkennen, daß im Frequenzbereich 2 und 3 (vgl. Fig. 3) im Maximum die gewünschten 12 dB erreicht werden, durch die hohe Güte der Bandfilter tritt jedoch eine hohe Welligkeit auf, die zwischen dem Frequenzbereich 2 und 3 eine erwünschte Amplitudenabsenkung zur Folge hat. Der Amplitudengang va geht von Bandfiltern geringer Güte mit Q = 0,2 aus, wodurch die Welligkeit vermieden wird. Die geringe Güte hat jedoch zur Folge, daß die einzelnen Frequenzbereiche ni voneinander nicht mehr unabhängig sind, sondern daß eine unerwünschte Überlagerung benachbarter Frequenzbereiche stattfndet. Somit überhöht sich der Amplitudengang va zwischen den Frequenzbereichen 2 und 3 bis auf 17 dB und übersteigt dabei erheblich den eingestellten Pegel von 12 dB. Eine gute Annäherung an den gewünschten Amplitudengang von Fig. 1 stellt die strichpunktierte Linie vs dar, die für die Frequenzbereiche 2 und 3 exakt einen Pegel von 12 dB aufweist und für die anderen Frequenzbereiche den Wert 0 dB einnimmt, wobei die Übergänge glatt und möglichst schmal sind. Mit der Erfindung wird dieser Amplitudengang vs ermöglicht.

Fig. 4 zeigt im Blockschaltbild die Grundstruktur einer Filterschaltung Fi für einen Equalizer nach der Erfindung. Jede Filterschaltung bildet eine Stufe der Gesamtfilteranordnung und definiert ferner eine Frequenzgrenze fg. Bei dieser Filterschaltung Fi wird zur Steuerung des Amplitudenganges v die Parallelschaltung eines Tiefpasses tp und eines Hochpasses hp verwendet, deren Frequenzverläufe so beschaffen sind, daß bei gleicher Verstärkung des Tiefpasses und des Hochpasses für die Parallelanordnung ein möglichst glatter Amplitudengang v resultiert. Dies ist dann der Fall, wenn die Frequenzgänge des Tiefpasses und des Hochpasses durch komplementäre Übertragungsfünktionen miteinander verkoppelt sind. Im einfachsten Fall weist der Tiefpaß hierzu die Übertragungsfunktion h(tp) = g1 • (1+z⁻¹)/2 und der Hochpaß die Übertragungsfunktion h(hp) = g2 · (1-z⁻¹)/2 auf. Die Faktoren g1, g2 stellen dabei Gewichtungsfaktoren dar. Sind diese einander gleich, also g1 = g2 = g, dann gilt für die Addition der beiden Übertragungsfunktionen h = h(tp) + h(hp) folgende Beziehung:
h = g • (1+z⁻¹)/2+ g • (1- z⁻¹)/2 = g

Dies besagt, daß bei einer Parallelschaltung eines entsprechenden Tief- und Hochpasses der resultierende Amplitudengang glatt verläuft und der Gewichtungsfaktor g einem einheitlichen Verstärkungspegel des digitalen Signals am Ausgang der Parallelschaltung entspricht. Die resultierende Übertragungsfunktion h hat somit auf das digitale Signal keinen Einfluß, außer daß gegebenenfalls durch den Gewichtungsfaktor die Amplitude geändert wird.

Werden aufwendigere Tief- und Hochpässe verwendet, dann wird die Selektionsflanke des Tiefpasses und Hochpasses steiler, wobei bei gleichen Gewichtungen der gesamte Amplitudengang immer noch möglichst glatt bleibt. Derartige komplementäre Übertragungsfunktionen sind ausführlich in dem Fachbuch von P.P. VAIDYANATHAN mit dem Titel "Multirate Systems And Filter Banks", im Kapitel 5, "Maximely Decimated Filter Banks" , Seiten 188 bis 285 beschrieben. Wie in der dortigen Einführung, Abschnitte 5.0 bis 5.02 auf den Seiten 188 bis 191 angegeben ist, ist es zum Beispiel schon lange bekannt, daß digitalisierte Signale mittels eines Tiefpasses und Hochpasses frequenzmäßig aufgespalten und danach ohne Signalverlust wieder zusammengefügt werden können. Im angelsächsischen Sprachgebrauch werden derartige Filterkombinationen auch als "Power Symmetric Filter", "Power Complementary Filter", "Quadratur Mirror Filter" bzw. kurz "QMF" oder kombiniert als "Power Symmetric QMF" bezeichnet. Allerdings findet in keiner der Filterschaltungen nach der Erfindung eine Abtastratenumsetzung wie in den Filterbeispielen der genannten Literatur statt, weil dies durch die Kaskadierung im Equalizer zu Verzerrungen infolge von Aliassignalen führen würde.

In Fig. 4 wird die Filterschaltung Fi am Eingang ei mit einem digitalen Signal gespeist, das entweder direkt das ursprüngliche Eingangssignal ist oder bereits einer vorausgehenden Filterschaltung Fi entstammt. In der Regel wirkt sich der Durchlaßbereich des Tiefpasses tp oder des Hochpasses hp nicht auf den Wert des digitalen Signals aus, so daß in den Durchlaßbereichen von einer Verstärkung mit 0 dB ausgegangen werden kann. Dem entsprechen die Amplitudengänge vt und vh in Fig. 5. Die gewünschte Signalanhebung oder -absenkung wird bei einem derartigen Tiefpaß oder Hochpaß durch einen Multiplizierer mt bzw. mh erreicht, der dem Tiefpaß tp bzw. dem Hochpaß hp nachgeschaltet ist. Dem jeweiligen Multipliziereingang wird die Gewichtung g1 bzw. g2 als Multiplikationsfaktor zugeführt und zwar für den Tiefpaßzweig der Multiplikationsfaktor kt und für den Hochpaßzweig der Multiplikationsfaktor kh. Selbstverständlich können die Filterschaltungen Fi hardware- oder softwaremäßig oder gar in gemischter Form realisiert sein. Es ist dabei auch möglich, daß die Multiplizierer mt, mh bereits Teil des Tiefpasses oder Hochpasses sind, dann ist deren Amplitudengang v im Durchlaßbereich nicht mehr 0 dB, sondern entspricht dem Multiplikationsfaktor kt bzw. kh. In Fig. 4 werden die Ausgangssignale des Tiefpaß- und Hochpaßsignalzweiges mittels einer Kombinationsstufe wieder vereinigt, die im einfachsten Fall aus einem Addierer ad besteht. Dessen Ausgangssignal ist an einem Ausgang ao abgreifbar und wird einer nachfolgenden Filterschaltung Fi oder einem Daten- oder Signalausgang des Equalizers zugeführt.

Aus dem genannten Fachbuch von P.P. VAIDYANATHAN, Kapitel 3.6, "IIR Filters Based on two Allpass Filters", Seiten 84 bis 99 sind digitale QMF-Filterschaltungen bekannt, die für die Realisierung der komplementären Übertragungsfünktionen des Tief- und Hochpasses besonders geeignet sind. Sie enthalten anstatt eines separaten Tief- und Hochpasses zwei eingangsseitig parallelgeschaltete Teilfilterschaltungen, deren Ausgangssignale addiert bzw. subtrahiert das Tiefpaß- bzw. Hochpaßsignal liefern. Die beiden Teilfilterschaltungen bestehen dabei jeweils einem digitalen Allpaß, jedoch mit jeweils unterschiedlichem Phasenverlauf. Anstatt der Subtraktion der beiden Ausgangssignale kann selbstverständlich eine Addition stattfinden, das Ausgangssignal der zweiten Teilfilterschaltung muß dann vor dem zugehörigen Addierer lediglich negiert werden. Die Realisierung eines komplementären Tiefpaß/Hochpaßpaares ist mit derartigen Allpässen besonders einfach, da die Rechenoperationen für den Tiefpaß nur um eine einzige Subtraktion erweitert werden müssen, um den komplementären Hochpaß zu erhalten. So ergibt sich, daß bei der Verwendung dieser Allpässe für den Equalizer eigentlich nur Tiefpässe zu berechnen sind, die zudem noch einfach implementiert werden können. Bei herkömmlichen Equalizern sind echte Bandpässe erforderlich, deren Berechnung bei vergleichbarer Qualität erheblich aufwendiger ist. Die Gewichtung des Tiefpaß- und des Hochpaßzweiges erfolgt durch jeweils einen Multiplizierer nach dem Addierer und Subtrahierer bzw. den beiden Addierern.

In Fig. 5 ist schematisch der Amplitudengang vt, der dem Tiefpaß tp zugeordnet ist, und der Amplitudengang vh, der dem Hochpaß hp zugeordnet ist dargestellt. Für den Tiefpaß sind dabei zusätzlich die Amplitudengänge bei den Gewichtungen g1 = +6 dB, +3 dB und -3 dB dargestellt. Die zugehörige Frequenzgrenze fg teilt den gesamten Frequenzbereich in einen ersten, tieferliegenden Frequenzbereich fb1 und einen zweiten, höherliegenden Frequenzbereich fb2 ein, wobei der erste Frequenzbereich fb1 dem Durchlaßbereich des Tiefpasses tp und der zweite Frequenzbereich fb2 dem Durchlaßbereich des Hochpasses hp zugeordnet ist. Im Beispiel des um +6 dB verstärkten Tiefpaßsignales wird in Fig. 5 der zugehörige Amplitudengang vt' mit dem Amplitudengang vh des unverstärkten Hochpasses kombiniert, so daß sich ein resultierender Amplitudengang vr ergibt. Dieser weist im ersten Frequenzbereich fb1 einen Pegel von +6 dB auf und im zweiten Frequenzbereich fb2 einen Pegel von 0 dB. Die Selektionsflanke hat sich dabei geringfügig gegenüber der ursprünglichen Frequenzgrenze fg in Richtung höherer Frequenzen verschoben.

Aus Fig. 5 wird deutlich, daß mit einer einzigen Filterschaltung Fi zwei Frequenzbereiche ni in ihrem Pegel gesteuert werden können. Eine Pegelanhebung oder -absenkung im Tiefpaßsignalzweig beeinflußt den Pegel des ersten Frequenzbereiches fb1 und eine Pegelanhebung oder -absenkung des Hochpasses hp beeinflußt den Pegel des zweiten Frequenzbereiches fb2. Durch eine geschickte Kombination mehrerer hintereinandergeschalteter Filterschaltungen Fi kann somit jeder gewünschte Amplitudenverlauf eingestellt werden.

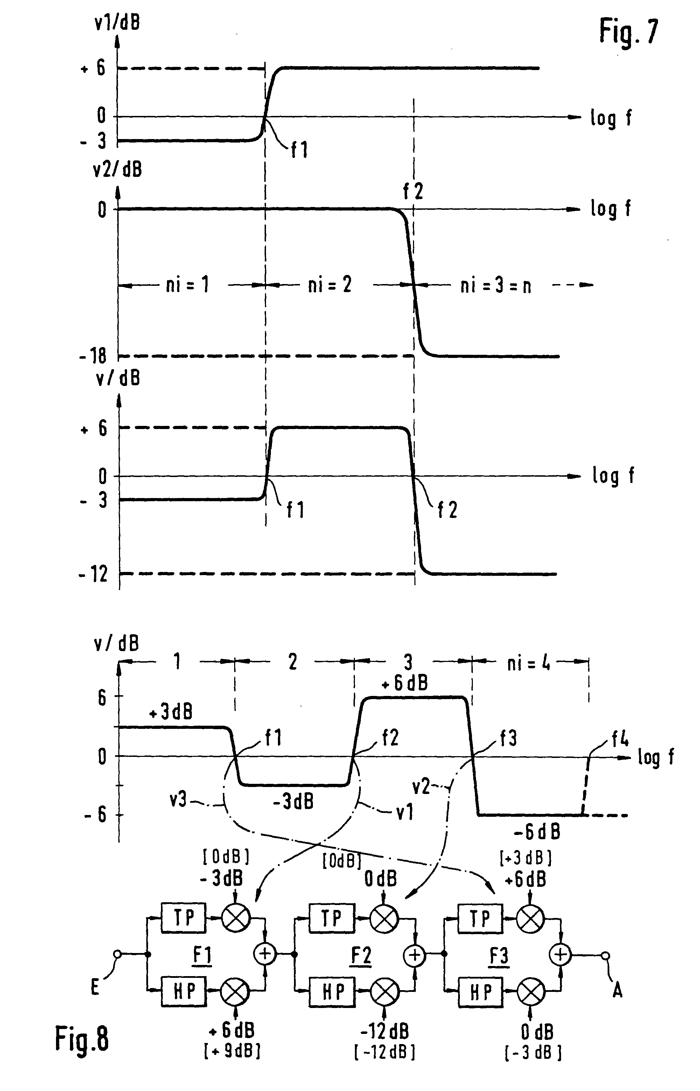

In Fig. 6 ist schematisch ein vollständiges Blockschaltbild eines erfindungsgemäßen Equalizers für drei Frequenzbereiche ni von 1 bis 3 dargestellt. Die drei Frequenzbereiche ni erfordern zwei Filterschaltungen F1, F2, die in Signalflußrichtung hintereinandergeschaltet sind und jeweils einen Tiefpaß tp1, tp2 und einen Hochpaß hp1, hp2 aufweisen. Der Eingang der ersten Filterschaltung F1 ist mit dem Dateneingang E des Equalizers und der Ausgang der zweiten Filterschaltung F2 mit dem Datenausgang A des Equalizers verbunden. Eine Einstelleinrichtung q für den Equalizer, die zum Beispiel eine manuelle Einstelleinrichtung gemäß Fig. 1 enthalten kann, liefert an ihrem Ausgang ein Equalizer-Steuersignal eq an eine Steuereinrichtung st. Das Equalizer-Steuersignal enthält in codierter Form den gewünschten Amplitudengang, wobei die Codierung beispielsweise durch die jeweilige Stellung der Schieberegler sr erfolgt. Bei Multimedia- und ähnlichen Anwendungen wird das Equalizer-Steuersignal eq selbstverständlich anders erzeugt, z.B. über eine Menu-Steuerung am Bildschirm oder automatisch über eine gespeicherte Einstellung.

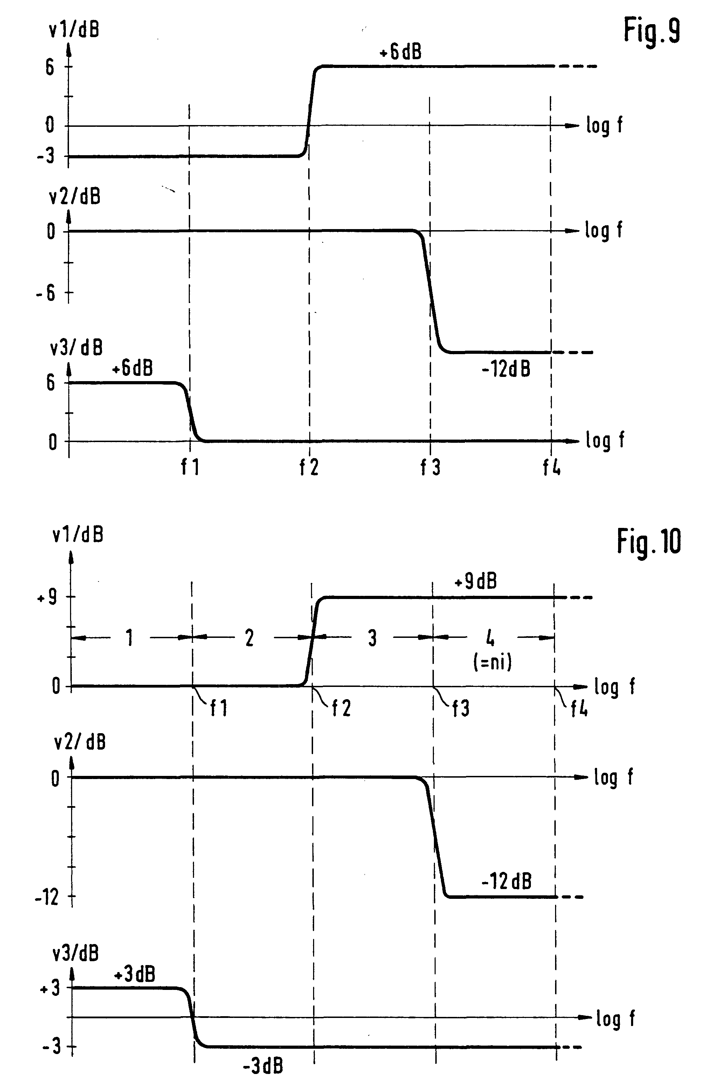

Die Steuereinrichtung st enthält den Algorithmus, um aus dem Equalizer-Steuersignal eq modifizierte Steuersignale ki zu bilden, die letztendlich die einzelnen Multiplikationsfaktoren k1 bis k4 darstellen. Besonders einfach und übersichtlich ist der Algorithmus, wenn durch den Amplitudengang v1 der ersten Filterschaltung F1 der Sollpegel des ersten und zweiten Frequenzbereiches 1 bzw. 2 exakt eingestellt wird und die zweite Filterschaltung F2 nur noch den relativen Pegelsprung vom 18 dB zwischen dem zweiten und dritten Frequenzbereich 2 bzw. 3 realisieren muß, was mittels des Amplitudenganges v2 erfolgt. Der Verlauf der Amplitudengänge v1, v2 und v ist in Fig. 7 dargestellt. Indem der Tiefpaßzweig in der zweiten Filterschaltung F2 auf 0 dB gesetzt wird, wird auch das Problem der mathematischen Überbestimmung der vier Multiplikationsfaktoren k1 bis k4 aus nur drei Pegelwerten -3 dB, +6 dB und -6 dB gelöst. Hierauf wird in Fig. 9 und Fig. 10 näher eingegangen.

Aus den gewünschten Pegelwerten des Amplitudenganges v des gesamten Equalizers folgen die einzelnen Multiplikationsfaktoren:

| | |
|---|---|
| k1 = -3 dB = 0,707 | im Tiefpaßzweig in der ersten Filterschaltung F1, |
| | |
| k2 = +6 dB = 2 | im Hochpaßzweig in der ersten Filterschaltung F1, |
| | |
| k3 = 0 dB = 1 | im Tiefpaßzweig in der zweiten Filterschaltung F2 und |
| | |
| k4 = -18 dB = 1/8 | im Hochpaßzweig in der zweiten Filterschaltung F2. |

Die Signalzusammenführung erfolgt in der ersten bzw. zweiten Filterschaltung F1 bzw. F2 mittels eines ersten bzw. zweiten Addierers ad1 bzw. ad2. Die Reihenfolge der einzelnen Filterschaltungen Fi zwischen dem Dateneingang E und dem Datenausgang A ist beliebig, auch bei einer beliebigen Anzahl von Filterschaltungen Fi.

Im Ausführungsbeispiel von Fig. 6 kann man auch leicht erkennen, daß sich für jeden Frequenzbereich ni der resultierende Pegel des Amplitudenganges v aus den Gewichtungen bzw. den Multiplikationsfaktoren der zugehörigen Tief- und Hochpässe ergibt. Das Produkt aus den zugehörigen Multiplikationsfaktoren liefert den resultierenden Pegel für den jeweiligen Frequenzbereich ni. Als zugehöriger Multiplikationsfaktor ist in dem jeweiligen Frequenzbereich nur derjenige Multiplikationsfaktor anzusehen, der in diesem Bereich dem Durchlaßzustand des Tief- oder Hochpasses zugeordnet ist. Der andere Multiplikationsfaktor, der dem Sperrzustand zugeordnet ist, wird nicht berücksichtigt. Damit gelten für die drei Frequenzbereiche, die in Fig. 6 und Fig. 7 dargestellt sind, folgende Produkte:

| | | |
|---|---|---|
| erster Frequenzbereich mit | ni = 1 | k1 • k3 = 1 / (SQR 2) • 1 = 0,707 = -3 dB |
| zweiter Frequenzbereich mit | ni = 2 | k2 • k3 = 2 • 1 = 2 = +6 dB |
| dritter Frequenzbereich mit | ni = 3 | k2 • k4 = 2 • 1/8 = 0,25 = -12 dB |

In Fig. 8 wird schematisch ein Ausführungsbeispiel für einen Equalizer mit vier Frequenzbereichen dargestellt, der entsprechend der Erfindung drei Filterschaltungen F1, F2, F3 erfordert. Abweichend zu Fig. 7 werden die einzelnen Multiplikationsfaktoren in einer anderen Reihenfolge gebildet. Mit der ersten Filterschaltung F1 werden nämlich nicht die Sollpegel der ersten Frequenzgrenze f1, sondern diejenigen der zweiten Frequenzgrenze f2 übernommen. Der Tiefpaßzweig wird mit -3 dB (zweiter Frequenzbereich) und der Hochpaßzweig mit +6 dB (dritter Frequenzbereich) gewichtet. Der zugehörige Amplitudengang v1 der ersten Filterschaltung F1 ist in Fig. 9 dargestellt.

Die zweite Filterschaltung F2 ist dem dritten und vierten Frequenzbereich an der dritten Frequenzgrenze f3 zugeordnet. Da der dritte Frequenzbereich mit +6 dB bereits seinen richtigen Wert hat, darf dieser Wert nicht mehr verändert werden, so daß der Tiefpaßzweig in der dritten Filterschaltung F3 den Gewichtungsfaktor 0 dB bekommt. Der Hochpaßzweig muß den relativen Pegelsprung zwischen +6 dB und -6 dB realisieren, wodurch der Hochpaßzweig die Gewichtung -12 dB bekommt. Der resultierende Amplitudengang v2 ist ebenfalls in Fig. 9 dargestellt.

Es bleibt jetzt nur noch der Pegelsprung von +3 dB auf -3 dB an der ersten Frequenzgrenze f1 übrig, der durch die dritte Filterschaltung F3 realisiert wird. Da mit -3 dB der Pegel des zweiten Frequenzbereiches schon seinen Sollwert aufweist, darf dieser Wert nicht mehr verändert werden, der Hochpaßzweig der dritten Filterschaltung F3 bekommt daher die Gewichtung 0 dB. Der zugehörige Tiefpaßzweig muß in aufsteigender Frequenzrichtung eine Amplitudenabsenkung von +3 dB auf -3 dB an der ersten Frequenzgrenze f1 realisieren, die einem relativen Pegelsprung von -6 dB entspricht. Dies wird dadurch erreicht, daß die Gewichtung des Tiefpaßzweiges der dritten Filterschaltung F3 auf +6 dB eingestellt wird.

Der gewünschte und auch resultierende Amplitudengang v des Equalizers ist in dem oberen Teil der Figur 8 dargestellt, während in Fig. 9 die zugehörigen Amplitudengänge v1, v2, v3 der drei Filterschaltungen F1, F2, F3 dargestellt sind. Der besseren Übersicht wegen ist in Fig. 8 keine Steuereinrichtung gezeigt und der jeweilige Wert der Multiplikationsfaktoren als dB-Größe angegeben. Zu jeder Gewichtung ist als Alternative in Fig. 8, in eckiger Klammer stehend, eine alternative Gewichtung angegeben, die ebenfalls zu dem gewünschten Amplitudengang v führt. Die zugehörigen Amplitudengänge v1, v2, v3 der drei Filterschaltungen F1, F2, F3 sind in Fig. 10 dargestellt. Ein Vergleich der Amplitudengänge von Fig. 7 und Fig. 10 zeigt, daß die Höhe und Richtung der relativen Pegelsprünge in beiden Fällen gleich ist. Die Amplitudenverläufe v1, v3 unterscheiden sich indessen voneinander durch eine konstante Pegelverschiebung um +3 dB bzw. -3 dB.

Wie in Fig. 6 so liegt auch in Fig. 8 eine Überbestimmung der sechs Multiplikationsfaktoren vor, die aus vier Sollpegeln +3 dB, -3 dB, +6 dB und -6 dB berechnet werden müssen. Es gibt daher eine unendliche Anzahl unterschiedlicher Lösungen, die sich jedoch nicht im grundsätzlichen Kurvenverlauf sondern nur im Gleichpegel unterscheiden. Rechnerisch sind diese Lösungen zwar gleichwertig, doch es können sich bei der praktischen Realisierung Probleme dadurch ergeben, daß der innere Dynamikumfang, also die interne Binärstellenzahl, jedes vernünftige Maß überschreitet und daß durch unnötige Pegelsprünge das Digitalisierungsrauschen vergrößert wird. Es ist daher sinnvoll, wie in Fig. 9 mit der absoluten Tiefpaß/Hochpaß-Einstellung dort zu beginnen, wo die subjektive Empfindlichkeit am größten ist, bei Audiosignalen also etwa bei 3000 Hertz. Von dort aus arbeitet man sich dann in beide Frequenzrichtungen weiter vor und beläßt die nicht mehr zu verändernden Frequenzbereiche mit 0 dB. Damit werden unnötige Pegelumschaltungen vermieden. Das Ausführungsbeispiel von Fig. 10 ist nicht mehr optimal, da im dritten Frequenzbereich ni = 3 die Gewichtungen + 9 dB und - 3 dB aufeinander treffen, um letzlich einen resultierenden Pegel von +6 dB zu bilden.

## Patentansprüche

1. Equalizer mit n Frequenzbereichen (ni) für digitalisierte Signale bei denen mittels n-1 in Signalflußrichtung kaskadierten Filterschaltungen (Fi; F1, F2), die digitale Tief- (tp) und digitale Hochpässe (hp) enthalten, ein gewünschter Amplitudengang (v) eingestellt ist, wobei die Selektionsflanken der digitalen Tief- und digitalen Hochpässe die Frequenzgrenze (fg) zwischen jeweils benachbarten Frequenzbereichen (fb1, fb2) definieren,
- die n-1 Filterschaltungen (Fi; F1, F2) enthalten in Signalflußrichtung jeweils eine Parallelschaltung mit einem der digitalen Tiefpässe (tp) und einem der digitalen Hochpässe (hp), wobei deren jeweilige Frequenzgänge durch komplementäre Übertragungsfunktionen miteinander verkoppelt und deren Ausgänge über eine Kombinationsstufe (ad; ad1, ad2) wieder zusammengeschaltet sind,
- eine relative Amplitudenanhebung oder -absenkung in Richtung aufsteigender Frequenzen, zwischen benachbarten Frequenzbereichen (fb1, fb2) erfolgt in der zugehörigen Filterschaltung (Fi; F1,F2) mittels Gewichtung der Ausgangssignale des digitalen Hoch- (hp) und Tiefpasses (tp), wobei
-- für die relative Amplitudenanhebung die Ausgangssignale des digitalen Hochpasses (hp) gegenüber denen des digitalen Tiefpasses (tp) stärker gewichtet sind oder
-- für die relative Amplitudenabsenkung die Ausgangssignale des digitalen Tiefpasses (tp) gegenüber denen des digitalen Hochpasses (hp) stärker gewichtet sind, und
- die Gewichtungseinstellung erfolgt durch eine Steuereinrichtung (st), die aus einem zugeführten Equalizer-Steuersignal (eq) modifizierte Steuersignale (kt, kh; kl bis k4) entsprechend der Kaskadierung der Filterschaltungen (Fi; F1, F2) bildet.

2. Equalizer nach Anspruch 1, dadurch gekennzeichnet, daß die Steuereinrichtung (st) die einzelnen Gewichtungen als Multiplikationsfaktoren (kt, kh; ki) bildet, mit denen die Ausgangssignale der digitalen Tief- (tp) und Hochpässe (hp) zu multiplizieren sind, wobei in jedem Frequenzbereich (ni) das Produkt aus den zugehörigen Gewichtungen dem gewünschten Pegelwert des Amplitudenganges (v) entspricht.

3. Equalizer nach Anspruch 2, dadurch gekennzeichnet, daß im Durchlaßbereich der digitalen Tief- (tp) und Hochpässe (hp) deren jeweilige innere Verstärkung einen Verstärkungsfaktor eins aufweist und die Ausgangsverstärkung jeweils mittels eines Multiplizierers (mt, mh) einstellbar ist, dessen jeweiligem Multiplikationseingang der zugehörige Multiplikationsfaktor (kt, kh; ki) als Steuersignal zugeführt ist.

4. Equalizer nach einem der Ansprüche 1 bis 3, dadurch gekennzeichnet, daß die digitalen Tief- (tp) und Hochpässe (hp) gemeinsam als "Quadratur Mirror Filter", vereinfacht auch als QMF bezeichnet, ausgebildet sind.

5. Equalizer nach einem der Ansprüche 1 bis 4, dadurch gekennzeichnet, daß mindestens in einer Filterschaltung (Fi; F2; F2, F3) der Multiplikationsfaktor (kt) für den Tiefpaß (tp) und /oder der Multiplikationsfaktor (kh) für den digitalen Hochpaß (hp) den Wert eins aufweist.

## Claims

1. An equalizer with n frequency ranges (ni) for digitized signals wherein a desired amplitude response (v) is adjusted by means of n-1 cascaded filter circuits (Fi; F1, F2) comprising digital low-pass filters (tp) and digital high-pass filters (hp), with the skirts of the selectivity curves of the digital low-pass and high-pass filters defining the frequency limit (fg) between adjacent frequency ranges (fb1, fb2);
- each of the n-1 filter circuits (Fi; F1, F2) contains, in the direction of signal flow, a parallel circuit with one of the digital low-pass filters (tp) and one of the digital high-pass filter (hp), the respective frequency responses of said digital low-pass and high-pass filters being linked by complementary transfer functions, and their outputs being interconnected via a combining stage (ad; ad1, ad2);
- a relative increase or decrease in amplitude in the direction of ascending frequencies between adjacent frequency ranges (fb1, fb2) is effected in the associated filter circuit (Fi; F1, F2) by weighting the outputs of the digital high-pass and low-pass filters (hp, tp);
-- for the relative increase in amplitude, the output signals from the digital high-pass filter (hp) are assigned a greater weight than those from the digital low-pass filter (tp), and
-- for the relative decrease in amplitude, the output signals from the digital low-pass filter (tp) are assigned a greater weight than those of the digital high-pass filter (hp); and
- the weighting is adjusted by a control unit (st) which forms modified control signals (kt, kh; k1 to k4) from an applied equalizer control signal (eq) according to the cascading of the filter circuits (Fi; F1, F2).

2. An equalizer as claimed in claim 1, characterized in that the control unit (st) forms the individual weights as multiplication factors (kt, kh; ki) by which the output signals from the digital low-pass and high-pass filters (tp, hp) have to be multiplied, and that in each frequency range (ni), the product of the associated weights corresponds to the desired level value of the amplitude response (v).

3. An equalizer as claimed in claim 2, characterized in that in the passbands of the digital low-pass and high-pass filters (tp, hp), the respective internal gains of the latter equal unity, and that the output gain of each of the low-pass and high-pass filters is adjustable by means of an associated multiplier (mt, mh) whose multiplication-factor input is supplied with the associated multiplication factor (kt, kh; ki) as the control signal.

4. An equalizer as claimed in any one of claims 1 to 3, characterized in that the digital low-pass and high-pass filters (tp, hp) are implemented as a quadrature mirror filter bank.

5. An equalizer as claimed in any one of claims 1 to 4, characterized in that in at least one of the filter circuits (Fi; F1, F2, F3), the multiplication factor (kt) for the low-pass filter (tp) and/or the multiplication factor (kh) for the digital high-pass filter (hp) have/has the value 1.

## Revendications

1. Egaliseur comportant n gammes de fréquences (ni) pour des signaux numériques, dans lesquels, au moyen de n - 1 circuits de filtrage (Fi ; F1, F2) qui sont branchés en cascade dans le sens de circulation des signaux et qui contiennent des filtres numériques passe-bas (tp) et passe-haut (hp), on règle une caractéristique d'amplitude désirée (v), les flancs de sélection des filtres numériques passe-bas (tp) et passe-haut (hp) définissant les limites de fréquence entre deux gammes de fréquences voisines (fb1, fb2),
- les n - 1 circuits de filtrage (Fi ; F1, F2) comprennent, à chaque fois, dans le sens de circulation des signaux, un circuit parallèle comportant un des filtres numériques passe-bas (tp) et un des filtres numériques passe-haut (hp), les caractéristiques de fréquence respectives des filtres étant couplées entre elles au moyen de fonctions de transfert complémentaires et les sorties des filtres étant interconnectées de nouveau par l'intermédiaire d'un étage de combinaison (ad ; ad1, ad2)
- un renforcement ou un affaissement relatif de l'amplitude dans le sens des fréquences croissantes, entre des gammes de fréquences voisines (fb1, fb2) se produit dans le circuit de filtrage correspondant (Fi ; F1, F2) au moyen de la pondération des signaux de sortie du filtre numérique passe-haut (hp) et du filtre numérique passe-bas (tp), dans lequel
-- pour le renforcement relatif de l'amplitude, les signaux de sortie du filtre numérique passe-haut (hp) sont plus fortement pondérés par rapport à ceux du filtre numérique passe-bas (tp) ou
- - pour l'affaissement relatif de l'amplitude, les signaux de sortie du filtre numérique passe-bas (tp) sont plus fortement pondérés par rapport à ceux du filtre numérique passe-haut (hp) et
- le réglage de la pondération est réalisé au moyen d'un dispositif de commande (st) qui forme, à partir d'un signal de commande de l'égaliseur (eq) qui est envoyé, des signaux de commande modifiés (kt, kh ; k1 à k4) en correspondance avec la séquence en cascade des circuits de filtrage (Fi ; F1, F2).

2. Egaliseur selon la revendication 1, caractérisé en ce que le dispositif de commande (st) forme les pondérations individuelles sous la forme de facteurs de multiplication (kt, kh ; ki) par lesquels les signaux de sortie du filtre numérique passe-haut (hp) et du filtre numérique passe-bas (tp) doivent être multiplié, le produit provenant des pondérations correspondantes correspondant, dans chaque gamme de fréquences (ni), à la valeur de niveau désirée de la caractéristique d'amplitude (v).

3. Egaliseur selon la revendication 2, caractérisé en ce que, dans la bande passante du filtre numérique passe-haut (hp) et du filtre numérique passe-bas (tp), leur amplification intérieure respective a un facteur d'amplification de un et en ce que l'amplification de sortie peut être réglée, à chaque fois, au moyen d'un multiplicateur (mt, mh) à l'entrée de multiplication respective duquel on envoie le facteur de multiplication (kt, kh ; ki) en tant que signal de commande.

4. Egaliseur selon l'une quelconque des revendications 1 à 3, caractérisé en ce que le filtre numérique passe-haut (hp) et le filtre numérique passe-bas (tp) sont conformés ensemble sous la forme d'un « filtre miroir en quadrature », désigné aussi simplement par QMF.

5. Egaliseur selon l'une quelconque des revendications 1 à 4, caractérisé en ce que, au moins dans un circuit de filtrage (Fi; F1, F2, F3), le facteur de multiplication (kt) pour le filtre numérique passe-bas (tp) et/ou le facteur de multiplication (kh) pour le filtre numérique passe-bas (tp) est à la valeur un.
